# EUROPÄISCHE PATENTANMELDUNG

(11) **EP 0 653 791 A1**
(43) Veröffentlichungstag der Anmeldung: **17.05.1995**
(21) Anmeldenummer: 94116651.4
(22) Anmeldetag: 21.10.1994
(51) Int. Cl.: H01L 23/544

(54) **Vorrichtung zum Beschriften von Werkstücken**

(30) Priorität: 12.11.1993 DE 4338774
(71) Anmelder: Carl Baasel Lasertechnik GmbH, D-82319 Starnberg (DE)
(72) Erfinder: Langhans, Lutz, Dr., D-82319 Starnberg (DE)
(74) Vertreter: Klunker . Schmitt-Nilson . Hirsch

(57) **Zusammenfassung**

Bei einer Vorrichtung zum Beschriften von IC-Gehäusen (IC1, ... IC10) mit Hilfe eines Laserstrahls erfolgt eine gleichzeitige Beschriftung mehrerer IC-Gehäuse (IC1, ... IC5) mit mehreren Beschriftungs-Laserstrahlen (B1, ... B5), die von einer zwischen einer Laserstrahlquelle (2) und einem Schreibkopf (6, 8) befindlichen Strahlteilereinheit erzeugt werden. Durch zwei parallele Transportbahnen kann im Gegentaktbetrieb gearbeitet werden. Während auf der einen Bahn gleichzeitig beispielsweise fünf IC-Gehäuse beschriftet werden, erfolgt ein Vorschub auf der anderen Bahn um eine der Länge einer Reihe aus fünf IC-Gehäusen entsprechende Strecke. Anschließend werden die Beschriftungslaserstrahlen (B1, ... B5) auf die andere Transportbahn mit den darauf befindlichen IC-Gehäusen (IC6, ... IC10) gerichtet, während das Transportband mit den gerade beschrifteten Seitenstücken weitergerückt wird.

## Beschreibung

Die Erfindung betrifft eine Vorrichtung zum Beschriften von Werkstücken, insbesondere IC-Gehäusen, mittels Laserstrahl, mit einer Werkstückzuführeinrichtung, die die zu beschriftenden Werkstücke einer Beschriftungszone zuführt, einer Laserstrahlquelle und einer Ablenkeinheit mit Optik, mit der ein Beschriftungs-Laserstrahl auf die Oberfläche der zu beschriftenden, in der Beschriftungszone befindlichen Werkstücke fokussierbar ist.

Derartige Vorrichtungen sind bekannt und werden insbesondere zum Beschriften von IC-Gehäusen eingesetzt. Die Beschriftung wird in Form einer Gravur mit Hilfe des Laserstrahls "eingebrannt", wobei die Beschriftung beispielsweise den Namen des Herstellers, die Typenbezeichnung und dergleichen umfaßt. Diese Information wird der Laserstrahlquelle und der Steuerung der Ablenkeinheit zugeführt, um den Laserstrahl abhängig von der Beschriftungsinformation zu modulieren oder ein-/auszuschalten, wobei die Ablenkeinheit dafür sorgt, daß der Laserstrahl mit der geeigneten Geschwindigkeit über die zu beschriftende Fläche geführt wird. Die Optik dient dazu, den Laserstrahl exakt in der Beschriftungsebene zu fokussieren. Die Beschriftungsdauer für ein derartiges Werkstück liegt unter einer halben Sekunde. Der Vorschub der zu beschriftenden Werkstücke mit Hilfe der Werkstückzuführeinheit erfolgt intermittierend, wobei die Vorschubzeit innerhalb jedes Beschriftungszyklus etwa genauso lang ist wie die Beschriftungszeit. Um einen höheren Durchsatz zu erzielen, ist es bekannt, zwei Transportbahnen parallel nebeneinander anzuordnen und die Anlage im Gegentaktbetrieb zu betreiben, d. h., während die Beschriftung eines in der einen Beschriftungszone befindlichen Werkstücks erfolgt, erfolgt in der anderen Transportbahn eine Vorschubbewegung. Wenn die Beschriftung in der ersten Beschriftungszone abgeschlossen ist, wird der Laserstrahl auf die andere Beschriftungszone gerichtet, in die zwischenzeitlich ein weiteres zu beschriftendes Werkstück gerückt wurde.

Um den Durchsatz einer solchen Anlage zu erhöhen, kann man daran denken, mehrere Beschriftungsköpfe mit jeweils zugehöriger Laserstrahlquelle und Ablenkeinheit hintereinander oder nebeneinander anzuordnen, um gleichzeitig mehrere Werkstücke beschriften zu können. Dies ist allerdings besonders kostenintensiv, weil sich die Kosten der Anlage im Vergleich zu einer Anlage mit einem Schreibkopf um den Faktor der gleichzeitig zu beschriftenden Werkstücke erhöhen.

Der Erfindung liegt die Aufgabe zugrunde, eine Vorrichtung zum Beschriften von Werkstücken der eingangs genannte Art anzugeben, die bei vergleichsweise geringen zusätzlichem Aufwand eine erhebliche Steigerung des Durchsatzes an beschrifteten Werkstücken gestattet.

Erfindungsgemäß wird diese Aufgabe dadurch gelöst, daß eine Strahlteilereinheit vorgesehen ist, der den von der Laserstrahlquelle abgegebenen Laserstrahl in mehrere Teilstrahlen aufteilt, die über dieselbe Ablenkeinheit mit Optik geführt werden, um gleichzeitig mehrere Beschriftungs-Laserstrahlen zu erhalten, von denen jede auf eines von mehreren in der Beschriftungszone befindlichen Werkstücken fokussiert wird.

Die Beschriftungszone nimmt bei der erfindungsgemäß ausgebildeten Vorrichtung nicht nur ein Werkstück, sondern eine Gruppe von Werkstücken auf, die vorzugsweise in einer Reihe hintereinander angeordnet sind. Der von der Werkstückzuführeinrichtung bewirkte Vorschub erfolgt dann um eine Strecke, die der Länge der Reihe aus mehreren Werkstücken entspricht. Bei dem Beschriftungsvorgang werden gleichzeitig mehrere Beschriftungs-Laserstrahlen synchron über die in der Beschriftungszone befindlichen Werkstücke geführt. Die Anzahl von Teilstrahlen und die dementsprechende Ausgestaltung der Strahlteilereinheit hängen von der für die Beschriftung der einzelnen Werkstücke benötigten Energie sowie von der Energie des von der Laserstrahlquelle gelieferten Laserstrahls ab. Im einfachsten Fall liefert ein Strahlteiler zwei Teilstrahlen, es können jedoch auch drei, vier und mehr Teilstrahlen erzeugt werden, um eine entsprechend große Anzahl von Werkstücken gleichzeitig zu beschriften.

Die Beschriftungszone ist eine imaginäre Stelle entlang des durch beispielsweise ein Transportband gebildeten Transportwegs. Oberhalb dieser Stelle befindet sich der Schreibkopf der Vorrichtung, und die Optik des Schreibkopfs fokussiert sämtliche Teil-Beschriftungs-Laserstrahlen auf die Oberfläche der einzelnen Werkstücke.

Verglichen mit der herkömmlichen Vorrichtung braucht praktisch nur eine Strahlteilereinheit zusätzlich vorgesehen zu werden, welche die benötigte Anzahl von Teilstrahlen liefert. Diese Teilstrahlen werden dann so auf den ersten Ablenkspiegel der Ablenkeinheit gerichtet, daß die Teilstrahlen auf dem Ablenkspiegel praktisch an derselben Stelle auftreffen. Die beiden Ablenkspiegel lenken dann die Teilstrahlen synchron auf die Optik, und von der Optik werden sämtliche Teilstrahlen aus Beschriftungs-Laserstrahlen auf die in der Beschriftungszone befindlichen Werkstücke fokussiert.

Die Strahlteilereinheit kann in herkömmlicher Weise mit Hilfe halbdurchlässiger Spiegel und vollständig reflektierender Spiegel aufgebaut sein. Alternativ kann mach auch einen holographischen Strahlteiler einsetzen.

Die erfindungsgemäß ausgebildete Vorrichtung läßt sich vorzugsweise derart ausgestalten, daß die Werkstückzuführeinrichtung zwei nebeneinander angeordnete Transportbahnen aufweist, denen jeweils eine Beschriftungszone zugeordnet ist, und daß das Zuführen der Werkstücke gruppenweise für eine der Anzahl von Teilstrahlen entsprechende Anzahl von Werkstücken im Gegentaktbetrieb erfolgt, wobei während der Beschriftung der einen Gruppe in der einen Beschriftungszone der anderen Beschriftungszone eine Gruppe von Werkstücken zugeführt wird und danach die Beschriftungs-Laserstrahlen auf die andere Beschriftungszone gerichtet werden.

Im folgenden werden Ausführungsbeispiele der Erfindung anhand der Zeichnung näher erläutert. Es zeigen:
Figur 1 eine schematische Ansicht einer Vorrichtung zum Beschriften von IC-Gehäusen, und
Figur 2 eine schematische Darstellung des Laserstrahlverlaufs der in Figur 1 dargestellten Vorrichtung.

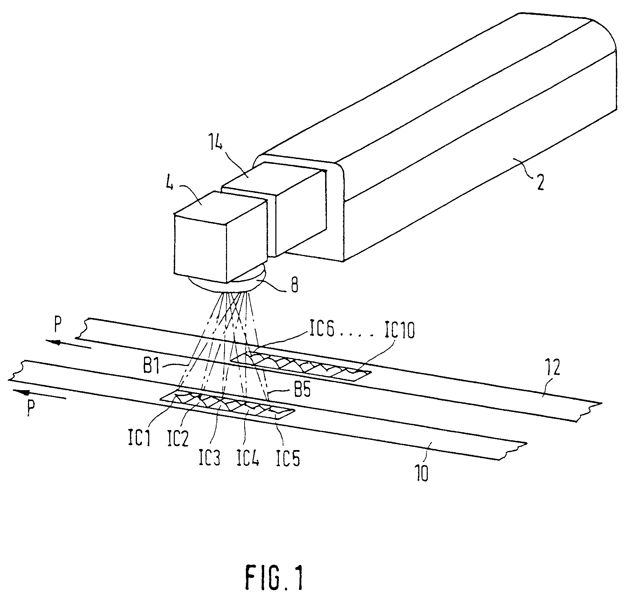

Figur 1 zeigt eine Vorrichtung zum Beschriften von IC-Gehäusen, d. h. von mit Anschlußstiften versehenen Kunststoffgehäusen, in denen sich ein Chip mit einer integrierten Schaltung befindet.

Eine Laserstrahlquelle 2 erzeugt einen Laserstrahl, der abhängig von der Schreibinformation in an sich bekannter Weise moduliert wird. Der modulierte Laserstrahl gelangt an einen Schreibkopf 6, der eine Ablenkeinheit 4 mit einer Fokussier-Optik 8 aufweist, welche mehrere Beschriftungs-Laserstrahlen B1, B2 ... B5 auf eine Beschriftungsebene fokussiert.

Die Beschriftungsebene wird definiert durch die Oberseite von auf einem Transportband 10 in Pfeilrichtung P intermittierend transportierten IC-Gehäusen IC1, IC2, ... IC5. Die Beschriftung nimmt ca. 0,2 bis 0,4 Sekunden in Anspruch. Anschließend werden die Beschriftungslaserstrahlen B1 - B5 auf eine benachbarte Beschriftungzone gerichtet, die gemäß Figur 1 durch fünf weitere in einer Reihe angeordnete IC-Gehäuse IC6, ... IC10 besetzt ist. Die IC-Gehäuse IC6, ... IC10 befinden sich auf einem parallel zu dem Transportband 10 ebenfalls in Pfeilrichtung P bewegten Transportband 12. Während die Beschriftung der in zu dem Transportband 10 gehörigen Beschriftungszone erfolgt, wird das andere Transportband 12 um eine Strecke weiterbewegt, welche der Länge der fünf IC-Gehäuse umfassenden Reihe entspricht. Während das eine Band die zu beschriftenden bzw. die beschrifteten IC-Gehäuse vorrückt, erfolgt gerade die Beschriftung in der zu dem anderen Transportband gehörigen Beschriftungszone.

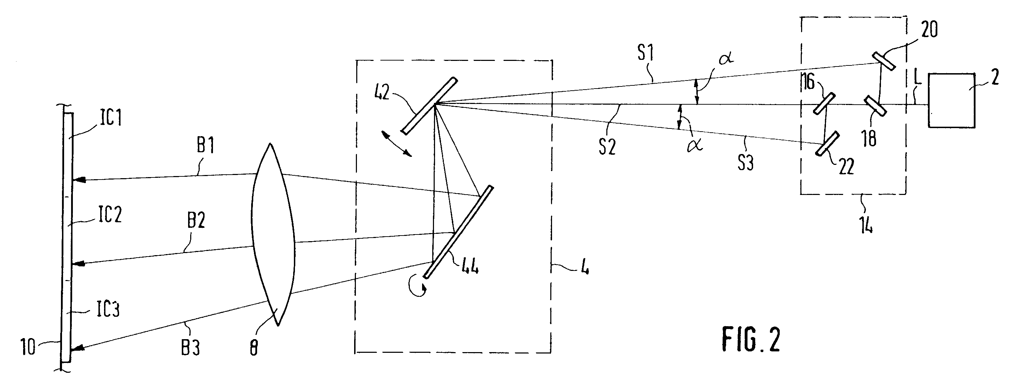

Figur 2 zeigt schematisch den Strahlverlauf für eine Vorrichtung der in Figur 1 dargestellten Art, wobei in Figur 2 aus Gründen der Vereinfachung jedoch nicht fünf, sondern lediglich 3 Beschriftungs-Laserstrahlen B1, B2 und B3 dargestellt sind. Links in Figur 2 ist ein Teil des Transportbands 10 dargestellt, auf dem sich in einer (imaginären) Beschriftungszone drei IC-Gehäuse IC1, IC2 und IC3 befinden. Die hier schematisch dargestellte Optik 8 dient zum Fokussieren von drei Teilstrahlen auf die Oberfläche der einzelnen IC-Gehäuse IC1, IC2 und IC3.

Die rechts in Figur 2 schematisch dargestellte Laserstrahlquelle 2 liefert einen Laserstrahl L, der auf einen teildurchlässigen Spiegel 18 fällt. Der durchgelassene Strahlanteil gelangt auf einen weiteren teildurchlässigen Spiegel 16, aus dem ein Teilstrahl S2 austritt. Der von dem teildurchlässigen Spiegel 16 abgelenkte Strahlanteil wird von einem Umlenkspiegel 22 als Teilstrahl S3 unter einem Winkel α bezüglich des Teilstrahls S2 auf die Ablenkeinheit 4 gerichtet. Der von dem teildurchlässigen Spiegel 18 abgelenkte Strahlanteil wird von einem Umlenkspiegel 20 als Teilstrahl S1 und einem Winkel α bezüglich des Teilstrahls S2 auf die Ablenkeinheit 4 gerichtet.

Die durch die teildurchlässigen Spiegel 16 und 18 und die Umlenkspiegel 20 und 22 gebildete Strahlteilereinheit ist hier in herkömmlicher Weise ausgebildet und wird als bauliche Einheit zwischen die Laserstrahlquelle 2 und die Ablenkeinheit 4 eingefügt.

Die Ablenkeinheit 4 ist in bekannter Weise ausgebildet und enthält einen ersten Ablenkspiegel 42, dessen Schwenkachse senkrecht zur Zeichenebene verläuft, so daß er sich in Richtung des Doppelpfeils zu bewegen vermag, und einen zweiten Ablenkspiegel 44, dessen Schwenkachse in der Zeichnungsebene liegt. Die von der Ablenkeinheit 4 in x- und y-Richtung (innerhalb der Zeichnungsebene und senkrecht zur Zeichnungsebene) abgelenkten Teilstrahlen S1, S2 und S3 werden von der Optik 8 als Beschriftungs-Laserstrahlen B1, B2 und B3 auf die zu beschriftenden IC-Gehäuse IC1, IC2 und IC3 gerichtet und fokussiert, wobei die Brennebene jedes Beschriftungs-Laserstrahls etwa der Oberseite der zu beschriftenden IC-Gehäuse entspricht.

Die Beschriftungs-Laserstrahlen B1, B2 und B3 bewegen sich gemäß Figur 2 in der Zeichnungsebene sowie senkrecht zur Zeichnungsebene, so daß der Brennpunkt jedes einzelnen Strahls über das betreffende IC-Gehäuse wandert und dort die Beschriftung entsprechend der Energie des modulierten Laserstrahls einbrennt.

In Abwandlung des oben beschriebenen Ausführungsbeispiels kann die in Figur 1 dargestellte Anlage auch mit lediglich einem einzigen Transportband, aber auch mit drei parallel geführten Transportbändern ausgeführt werden. Während oben als Beispiel die Beschriftung von IC-Gehäusen erläutert wurde, läßt sich die erfindungsgemäße Vorrichtung auch zur Beschriftung anderer Werkstücke einsetzen, insbesondere solcher Werkstücke, die sich mit Laserstrahlen relativ geringer Energie beschriften lassen. Es kommen also vorzugsweise Kunststoff-Werkstücke in Betracht.

Die in Figur 2 rechts oben dargestellte Strahlteilereinheit 14 kann auch in an sich bekannter Weise als holographischer Strahlteiler ausgebildet sein.

In Figur 1 und Figur 2 sind fünf bzw. drei IC-Gehäuse dicht an dicht jeweils in einer Reihe angeordnet. Die Anzahl gleichzeitig beschrifteter Werkstücke hängt ab von der Anzahl von Teilstrahlen. Dabei brauchen die zu beschriftenden Werkstücke nicht in einer Reihe angeordnet zu werden, man kann beispielsweise auch vier Werkstücke so anordnen, daß ihre Mittelpunkte auf einem Quadrat oder Rechteck liegen. Dabei muß der Strahlteiler dann so ausgestaltet werden, daß die einzelnen Teilstrahlen nicht nur - wie in Figur 2 gezeigt - in einer Ebene einen Winkel zueinander bilden, sondern auch räumlich bestimmte Winkel zueinander bilden. Andere Anordnungen von Teilstrahlen bzw. gleichzeitig zu beschriftenden Werkstücken sind denkbar.

## Patentansprüche

1. Vorrichtung zum Beschriften von Werkstücken (IC1, ... IC10), insbesondere IC-Gehäusen, mit Laserstrahl, mit einer Werkstückzuführeinrichtung (10, 12), die die zu beschriftenden Werkstücke einer Beschriftungszone zuführt, einer Laserstrahlquelle (2), einer Ablenkeinheit (4) mit Optik (8), mit der ein Laserstrahl auf die Oberfläche des zu beschriftenden, sich in der Beschriftungszone befindlichen Werkstücks (IC1, ... IC10) fokussierbar ist, **dadurch gekennzeichnet,** daß eine Strahlteilereinheit (14, 16 - 22) vorgesehen ist, die den von der Laserstrahlquelle (2) abgegebenen Laserstrahl (L) in mehrere Teilstrahlen (S1, S2, S3) aufteilt, die über dieselbe Ablenkeinheit (4) mit Optik (8) geführt werden, um gleichzeitig mehrere Beschriftungs-Laserstrahlen (B1, ...) zu erhalten, von denen jeder auf eines von mehreren in der Beschriftungszone befindlichen Werkstücken fokussiert wird.

2. Vorrichtung nach Anspruch 1, **dadurch gekennzeichnet,** daß die Werkstückzuführeinrichtung (10, 12) zwei nebeneinander angeordnete Transportbahnen (10, 12) aufweist, denen jeweils eine Beschriftungszone zugeordnet ist, und daß das Zuführen der Werkstücke (IC1, ... IC5; IC6, ... IC10) gruppenweise für eine der Anzahl von Teilstrahlen entsprechende Anzahl von Werkstücken im Gegentaktbetrieb erfolgt, wobei während der Beschriftung der einen Gruppe in der einen Beschriftungszone der anderen Beschriftungszone eine Gruppe von Werkstücken zugeführt wird und danach die Beschriftungs-Laserstrahlen auf die andere Beschriftungszone gerichtet werden.

3. Vorrichtung nach Anspruch 1 oder 2, **dadurch gekennzeichnet,** daß von der Strahlteilereinheit (14) gelieferte Teilstrahlen (S1, S2, S3) unter gegenseitigen Winkeln (α) derart auf den ersten Ablenkspiegel (42) der Ablenkeinheit (4) gerichtet werden, daß sie etwa an derselben Stelle auf den Ablenkspiegel (42) auftreffen.

4. Vorrichtung nach einem der Ansprüche 1 bis 3, **dadurch gekennzeichnet,** daß die Beschriftungszone mehrere in einer Reihe angeordnete Werkstücke aufnimmt.
